# EUROPEAN PATENT APPLICATION

(11) **EP 4 723 860 A1**
(43) Date of publication of application: **08.04.2026**
(21) Application number: 25183855.3
(22) Date of filing: 18.06.2025
(51) Int. Cl.: H10P 72/30

(54) **LOCKING/UNLOCKING MODULE FOR WAFER CARRIER LOAD PORT**

(30) Priority: 03.10.2024 TW 113137723
(71) Applicant: Brillian Network & Automation Integrated System Co., Ltd., 350 Zhunan Township, Miaoli County (TW)
(72) Inventor: HUNG, Yu-Wei, 350 Miaoli County (TW)
(74) Representative: Lang, Christian

(57) **Abstract**

A locking and unlocking module (100) for a wafer carrier load port (10) includes a transmission assembly (120), an actuator (110), a gear (130), and a locking latch (140). The transmission assembly (120) includes a linear guide (122) and a linear moving member (124) slidable along the linear guide (122), and the linear moving member (124) is provided with a plurality of toothed structures (124a) arranged substantially in a straight line. The actuator (110) is coupled to the linear moving member (124) and configured to reciprocate the linear moving member (124) in a direction parallel to the straight line. The gear (130) meshes with the toothed structures (124a) of the linear moving member (124), a locking latch (140) is disposed coaxially with and driven together with the gear (130), and the locking latch (140) is rotatable between a first position and a second position.

## Description

### CROSS-REFERENCE TO RELATED APPLICATION

This application claims the priority benefit of Taiwan application no. 113137723, filed October 3, 2024. The entirety of the above-mentioned patent application is hereby incorporated by reference herein and made a part of this specification.

### BACKGROUND

### Field of the Invention

The invention relates to a locking and unlocking module for a wafer carrier load port.

### Description of the Related Art

In semiconductor fabrication processes, the door of a wafer carrier can be opened and closed through various conventional mechanisms. For instance, a driving mechanism with its main transmission shaft driven by a motor can precisely control the angular position of a worm gear to open or close a wafer carrier door. However, such a design involves an excessive number of components and complex structures, resulting in difficulties in installation and maintenance, as well as higher manufacturing costs. Alternatively, other conventional design may use a pneumatic cylinder to actuate a linkage assembly for door opening and closing operations. Though simpler, this method tends to cause stress concentration at the linkage joints after prolonged use, resulting in damage that necessitates replacing the entire linkage assembly and thereby incurring high maintenance costs. Moreover, because sufficient space must be provided for the linkage rods to move in various directions, the mechanism module often occupies a larger space.

Therefore, it is desirable to provide a wafer carrier door-opening module having simplified components, ease of maintenance, lower manufacturing costs, reduced overall size, and the capability to offer high operational reliability as well as an extended service life.

### BRIEF SUMMARY OF THE INVENTION

The above-mentioned object is achieved by a locking and unlocking module and a wafer carrier load port according to claims 1 and 11. Preferred embodiments are subject matter of the dependent claims. The locking and unlocking module for a wafer carrier load port may include a transmission assembly, an actuator, a gear and a locking latch. The transmission assembly includes a linear guide and a linear moving member slidable along the linear guide, and the linear moving member is provided with a plurality of toothed structures arranged substantially in a straight line. The actuator is coupled to the linear moving member and configured to reciprocate the linear moving member in a direction parallel to the straight line. The gear meshes with the toothed structures of the linear moving member, a locking latch is disposed coaxially with and driven together with the gear, and the locking latch is rotatable between a first position and a second position.

The wafer carrier load port may include a frame, a carrier platform and a locking and unlocking module. The frame has a communication opening and a port door, and the port door is configured to cover the communication opening. The carrier platform is fixed to a first side of the frame and configured to carry a wafer carrier. The wafer carrier includes a main body and a door panel facing the communication opening, and the door panel has a hole. The locking and unlocking module is disposed on a second side of the frame opposite the carrier platform, and the locking and unlocking module includes a transmission assembly, an actuator, a gear and a locking latch. The transmission assembly is disposed on a first side of the port door opposite the carrier platform, and the transmission assembly includes a linear guide and a linear moving member slidable along the linear guide. The linear moving member is provided with a plurality of toothed structures arranged in a straight line, and the linear guide is disposed on the port door. The actuator is disposed on the first side of the port door opposite the carrier platform and coupled to the linear moving member, and the actuator is configured to reciprocate the linear moving member in a direction parallel to the straight line. The gear is disposed on the first side of the port door opposite the carrier platform and meshes with the toothed structures of the linear moving member. The locking latch includes a first end portion and a second end portion opposite the first end portion, the port door is located between the first end portion and the second end portion, the locking latch is disposed coaxially with and driven together with the gear, and the locking latch is rotatable to at least a first position and a second position. When the locking latch is in the first position, the locking latch mates with the hole of the door panel, and, when the locking latch is in the second position, the door panel is separable from the main body.

Based on the above, the invention achieve at least one of the following advantages or effects. According to the above embodiments, a pneumatic cylinder can be used to drive the linear moving member, and the linear motion of the moving member can be converted into rotational motion of the locking latch through a gear. As a result, only a simple mechanism is required to precisely open and close the door panel of a wafer carrier, thereby reducing the number of components required and lowering manufacturing costs. Furthermore, by coordinating the linear moving member and the gear, the locations subjected to higher stress in the module are confined to the meshing region between the linear moving member and the gear, thus preventing the pneumatic cylinder from bearing excessive stress to avoid undue wear on the pneumatic cylinder. This arrangement extends the service life of the actuator, and, if the gear sustains damage from prolonged stress, replacing the gear is a straightforward process with relatively low maintenance costs.

Other objectives, features and advantages of the invention will be further understood from the further technological features disclosed by the embodiments of the invention wherein there are shown and described preferred embodiments of this invention, simply by way of illustration of modes best suited to carry out the invention.

### BRIEF DESCRIPTION OF THE DRAWINGS

FIG. 1 shows a schematic diagram of a wafer carrier load port according to an embodiment of the invention.
FIG. 2 shows an exploded view of a locking and unlocking module used in a wafer carrier load port according to an embodiment of the invention.
FIG. 3 is a top view of the locking and unlocking module illustrated in FIG. 2 after assembly.
FIG. 4 is a side view of the locking and unlocking module illustrated in FIG. 2 after assembly.
FIG. 5A and FIG. 5B are schematic diagrams illustrating different positions of the locking latch relative to the door panel of a wafer carrier in different operating states.
FIG. 6 is a schematic diagram illustrating another state of the locking and unlocking module.
FIG. 7 shows a schematic diagram of a wafer carrier load port having a locking and unlocking module according to an embodiment of the invention.

### DETAILED DESCRIPTION OF THE INVENTION

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the present invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the present invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

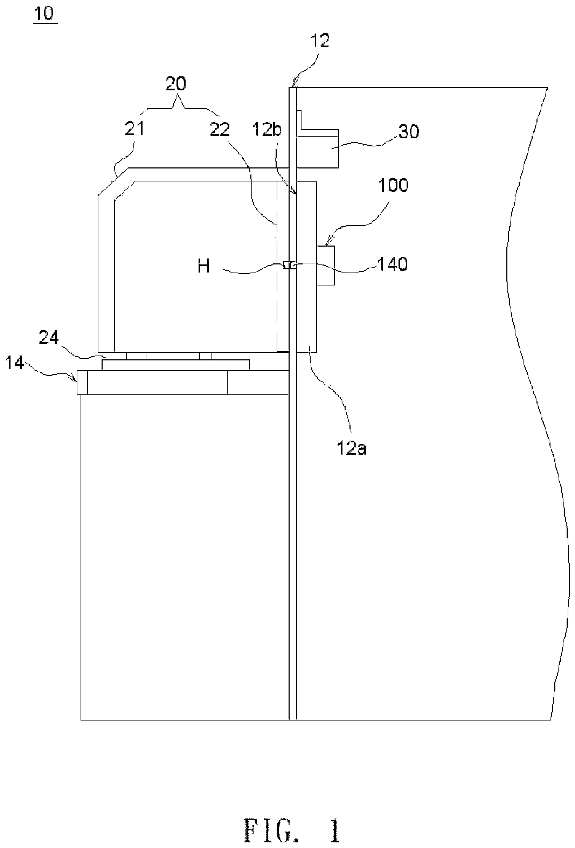

FIG. 1 shows a schematic diagram of a wafer carrier load port according to an embodiment of the invention. In this embodiment, a wafer carrier load port 10 includes a frame 12, a carrier platform 14, and a locking and unlocking module 100. The frame 12 has a port door 12a and a communication opening 12b, where the port door 12a is used to cover the communication opening 12b. The carrier platform 14 includes a contact surface 24 for supporting a wafer carrier 20. The wafer carrier 20 includes a main body 21 and a door panel 22, and the wafer carrier 20 may be, for example, a front-opening unified pod (FOUP). The locking and unlocking module 100 is disposed on one side of the frame 12 opposite the carrier platform 14 for opening or closing the door panel 22 of the wafer carrier 20. The locking and unlocking module 100 has at least one locking latch 140, and the door panel 22 of the wafer carrier 20 includes a hole H. When the carrier platform 14 pushes the wafer carrier 20 toward the communication opening 12b, the locking latch 140 enters the hole H and rotates to a latched position, and at this time the door panel 22 of the wafer carrier 20 is disengaged from the main body 21 of the wafer carrier 20 and is held by the locking and unlocking module 100. Subsequently, the port door 12a and the door panel 22 move together away from the main body 21, thereby separating the door panel 22 from the wafer carrier 20 and allowing the interior of the wafer carrier 20 to communicate with the external environment. Meanwhile, an air curtain device 30 continuously and uniformly blows clean gas toward the port door 12a, forming an air wall that reduces the risk of external contaminants directly entering the interior of the wafer carrier 20.

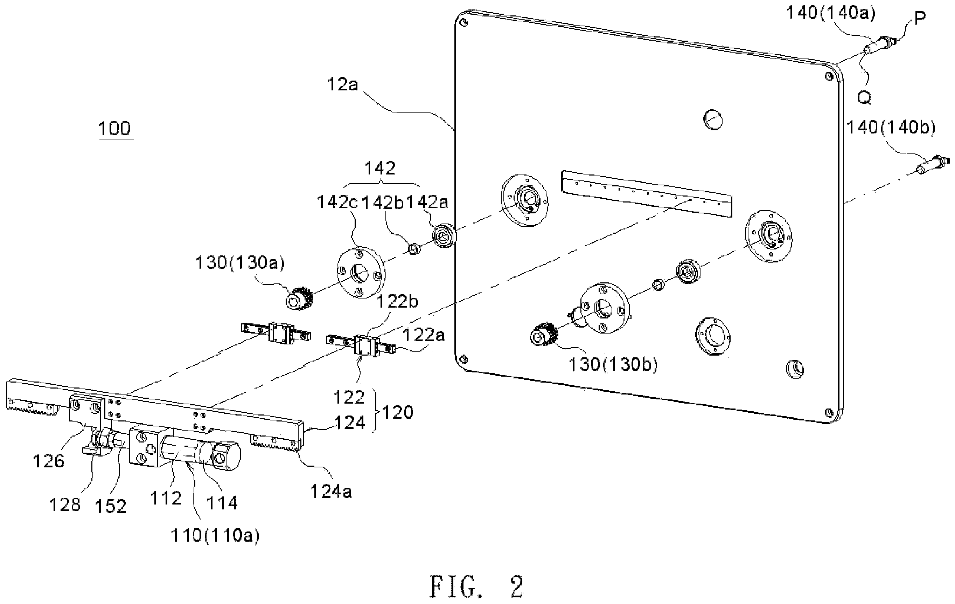

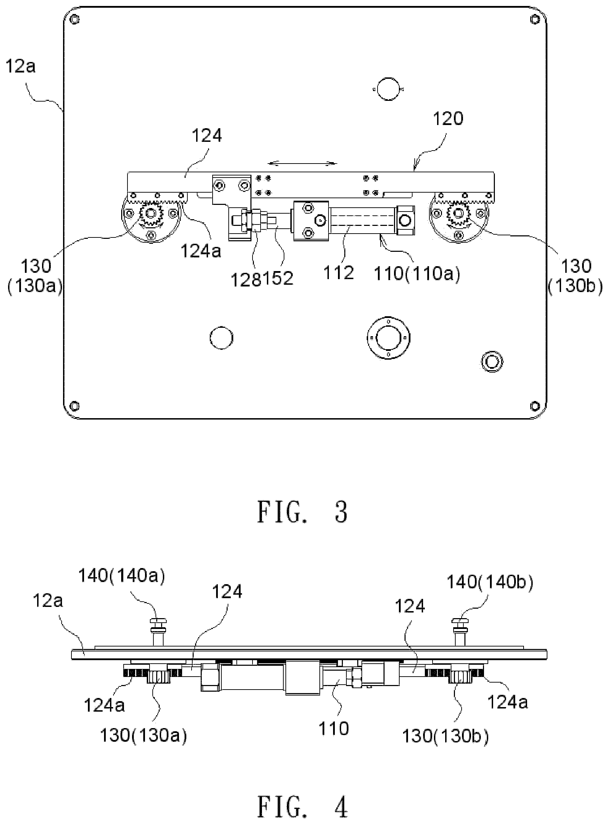

FIG. 2 shows an exploded view of a locking and unlocking module used in a wafer carrier load port according to an embodiment of the invention. FIG. 3 and FIG. 4 are respectively a top view and a side view of the locking and unlocking module illustrated in FIG. 2 after assembly. As shown in FIG. 2, the locking and unlocking module 100 includes an actuator 110, a transmission assembly 120, at least one gear 130, and at least one locking latch 140. In this embodiment, the actuator 110 may be a pneumatic cylinder 110a capable of generating a linear force. A piston rod 112 of the pneumatic cylinder 110a is connected to a piston 114 and an external mechanism, and, when the piston 114 moves inside the pneumatic cylinder 110a, the piston rod 112 transmits power to the external mechanism, thereby producing linear reciprocating motion. The transmission assembly 120 includes a linear guide 122 and a linear moving member 124. The linear guide 122 includes a rail 122a and a slider 122b, the rail 122a is fixed on the port door 12a, and the slider 122b is connected to the linear moving member 124. The linear moving member 124 is provided with multiple toothed structures 124a arranged substantially in a straight line. In this embodiment, the actuator 110 is connected to the linear moving member 124 (serving as the external mechanism) that receives power from the piston rod 112. This allows the linear moving member 124 to slide along the rail 122a via the slider 122b, thereby producing reciprocating motion in a straight-line direction. In this embodiment, the transmission assembly 120 may further include a connector 126, one end of the connector 126 is attached to the linear moving member 124, and the other end of the connector 126 is connected to the piston rod 112 of the pneumatic cylinder 110a via a floating joint 128. The piston rod 112 drives the connector 126 and thus propels the linear moving member 124 to slide along the rail 122a. The gear 130 meshes with the toothed structures 124a of the linear moving member 124, the locking latch 140 is pivotably mounted on a bearing assembly 142, and the locking latch 140 and the gear 130 are coaxial with each other and rotate together on a common axis. The locking latch 140 may include a first end portion P and a second end portion Q opposite the first end portion P. After assembly, the port door 12a can be located between the first end portion P and the second end portion Q. In this embodiment, the bearing assembly 142 may include a bearing 142a, a spacer ring 142b, and a bearing seat 142c. The bearing 142a is mounted on the shaft of the gear 130 to support the rotational locking latch 140. The spacer ring 142b is positioned between the bearing 142a and the gear 130 to provide sufficient clearance, thereby preventing direct friction and ensuring smooth rotation. The bearing seat 142c supports the bearing 142a and the spacer ring 142b and secures the entire bearing assembly 142 to the port door 12a.

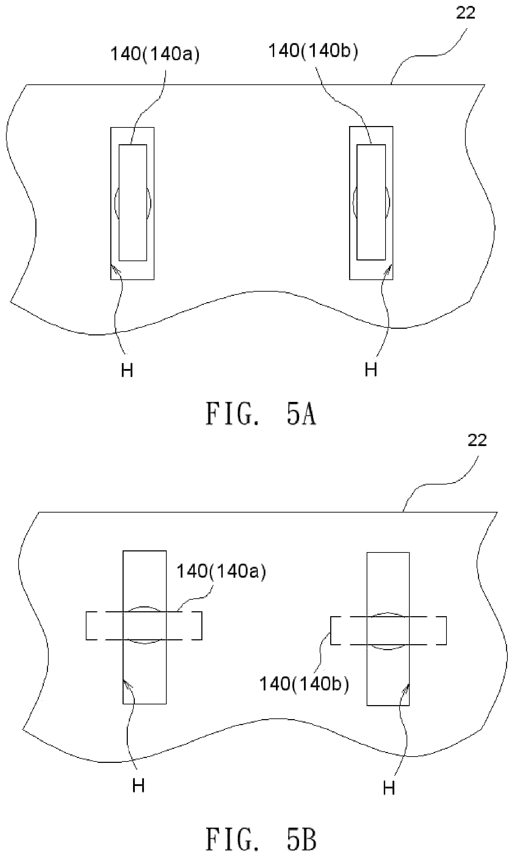

Referring to both FIG. 3 and FIG. 4, because the toothed structure 124a of the linear moving member 124 meshes with the gears 130a and 130b, when the linear moving member 124 moves back and forth in a linear direction, the toothed structure 124a may drive the gears 130a and 130b to rotate. Therefore, the locking latches 140a and 140b may rotate together with the rotating gears 130a and 130b, respectively. Each locking latch 140 may rotate between at least a first position and a second position, and the angular difference between these two positions may be, for instance, 90 degrees. FIG. 3 illustrates an example where the locking latches 140a and 140b are in the second position. FIG. 5A and FIG. 5B are schematic diagrams illustrating different positions of the locking latch 140 relative to the door panel 22 of the wafer carrier 20 in different operating states. Note that the shape of the locking latch 140 and the shape of the hole H depicted in FIGS. 5A and 5B are merely illustrative and do not limit the invention. First, when the door panel 22 is attached to the main body 21 of the wafer carrier 20, the locking latch 140 may be rotated to a longitudinal position (e.g., the first position) shown in FIG. 5A, thereby matching the shape of the longitudinal hole H. In this manner, the locking latch 140 can be freely inserted into, or withdrawn rearward from, the hole H in the door panel 22. Conversely, when the locking latch 140 is situated behind the door panel 22, it may be rotated, for example, by 90 degrees to reach a lateral position (e.g., the second position) shown in FIG. 5B. At this time, the locking latch 140a engages the hole H to unlock the door panel 22 from the main body 21 of the wafer carrier 20 and is retained in the locking and unlocking module 100. As a result, the port door 12a and the door panel 22 move together, thereby detaching the door panel 22 from the main body 21 and completing the door-opening operation of the wafer carrier 20.

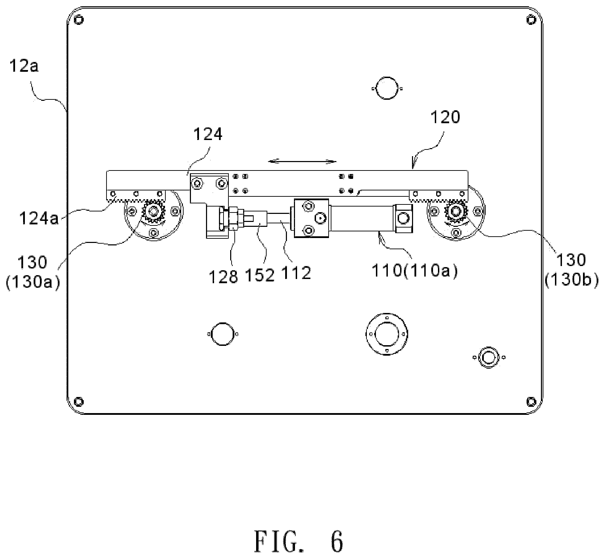

FIG. 6 is a schematic diagram illustrating another state of the locking and unlocking module 100, where the module components have shifted to a new position after the actuator 110 is actuated, as compared with FIG. 3. For example, the locking latches 140a and 140b in FIG. 6 are in the first position. As illustrated in FIG. 6, when the piston rod 112 extends, it drives the linear moving member 124 to slide, thereby causing the toothed structure 124a to turn the gears 130a and 130b. In turn, the locking latches 140a and 140b rotate to a position (e.g., the first position) that differs from that shown in FIG. 3. In at least some embodiments of the invention, the linear moving member 124 and the actuator 110 can be connected via a floating joint 128 to allow a degree of freedom during power transmission. This arrangement mitigates minor misalignment or offset that may arise between components and allows for fine adjustments of the rotational stopping position of the locking latch 140, thus improving the control accuracy of the locking and unlocking module 100. However, the invention is not limited to this configuration. In other embodiments, a universal joint may be used instead to couple the linear moving member 124 and the actuator 110. Furthermore, in at least some embodiments of the invention, the motion direction of the piston rod 112 may be parallel to that of the linear moving member 124, and a stopper 152 (shown in FIG. 6) may be disposed on the piston rod 112 of the pneumatic cylinder 110a to limit the stroke of the pneumatic cylinder 110a. This arrangement ensures that the piston rod 112 operates within a predetermined range and protects the pneumatic cylinder 110a and other linked components to thus extend their service life. This further enables precise control of the locking latch 140, ensuring that it rotates accurately to a predetermined angle and remains confined within a defined range of rotation. As shown in FIG. 6, in this embodiment, both the floating joint 128 and the stopper 152 are provided with threads so that they can be securely screwed onto the piston rod 112. This arrangement provides flexible adjustment of the stop positions of the floating joint 128 and the stopper 152 and facilitates their secure attachment at a desired location.

In one embodiment, the movement range of the linear moving member 124 may be from 10mm to 35 mm. Furthermore, in one embodiment, the toothed structure 124a of the linear moving member 124 and the gear 130 may be made of different materials; for example, the toothed structure 124a may be metal, and the gear 130 may be plastic, thereby improving meshing characteristics and enhancing reliability. Moreover, the linear moving member 124 is only required to incorporate a toothed structure 124a for meshing with the gear 130, and its configuration is not limited. For instance, the linear moving member 124 may take the form of a rack, a linear gear, or a timing belt having linearly arranged gear teeth.

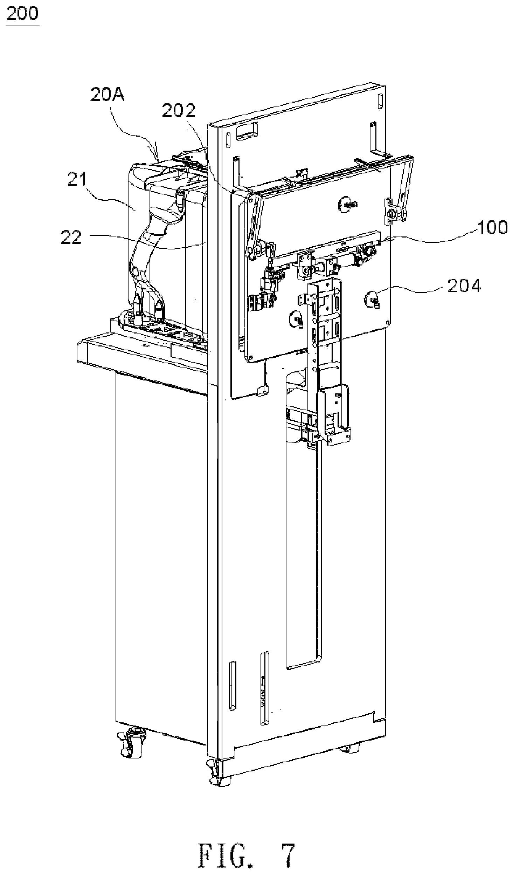

FIG. 7 shows a schematic diagram of a wafer carrier load port having a locking and unlocking module according to an embodiment of the invention. As shown in FIG. 7, when a front-opening unified pod (FOUP) 20A is docked with the wafer-carrier load port 200, control is exerted through the locking and unlocking module 100, causing the locking latch 140 to insert into a hole (not shown) in the door panel 22 of the FOUP 20A and then rotate the locking latch 140 to an unlocked position (e.g., the second position). Meanwhile, the door panel 22 is securely held against the port door 202 of the wafer carrier load port 200 by a suction mechanism 204. Once the suction is complete, the port door 202 together with the door panel 22 move away from the main body 21 of the FOUP 20A and are extracted through the communication opening 12b of the frame 12 (see FIG. 1). Subsequently, the port door 202 and the door panel 22 move downward to a designated position below the communication opening 12b, in order to prevent the door panel 22 from interfering with subsequent operations. After wafer-processing operations are finished, the port door 202 and the door panel 22 move back up to a position near the communication opening 12b, reinsert through the communication opening 12b, and move closer to the main body 21 of the FOUP 20A. Subsequently, the locking latch 140 is rotated to a locking position (e.g., the first position) that conforms to the shape of the hole of the door panel 22 to disengage the locking latch 140 from the hole. This action restores and secures the door panel 22 to the main body 21 of the FOUP 20A, thereby completing the entire door opening/closing process for the FOUP 20A.

According to the above embodiments, a pneumatic cylinder can be used to drive the linear moving member, and the linear motion of the moving member can be converted into rotational motion of the locking latch through a gear. As a result, only a simple mechanism is required to precisely open and close the door panel of a wafer carrier, thereby reducing the number of components required and lowering manufacturing costs. Furthermore, by coordinating the linear moving member and the gear, the locations subjected to higher stress in the module are confined to the meshing region between the linear moving member and the gear, thus preventing the pneumatic cylinder from bearing excessive stress to avoid undue wear on the pneumatic cylinder. This arrangement extends the service life of the actuator, and, if the gear sustains damage from prolonged stress, replacing the gear is a straightforward process with relatively low maintenance costs. Compared to the conventional worm-driven mechanism, the invention does not require complicated or costly precision mechanical parts, thereby significantly reducing manufacturing and maintenance costs. Moreover, conventional door-opening mechanisms that use symmetrical linkages tend to suffer damage at the linkage joints from stress concentration over long-term operation, thus necessitating replacement of the entire linkage assembly and leading to high maintenance costs. Besides, such design further requires sufficient space to accommodate multi-directional movement by each linkage rod, causing the overall module to be relatively large. In contrast, the invention provides a single-axis linear motion design to avoid the multi-dimensional movement needed by conventional symmetrical linkages, thus reducing the overall space occupied by the mechanism. Moreover, by confining the high-stress areas of the module to the meshing region between the linear moving member and the gear, the maintenance process for replacing the gear is significantly simpler and less costly compared to replacing an entire linkage assembly. Therefore, the invention provides a door-opening mechanism that at least simplifies the door-opening process, reduces both manufacturing and maintenance costs, and offers excellent operational precision along with ease of maintenance.

## Claims

1. A locking and unlocking module (100) for a wafer carrier load port (10), comprising:
a transmission assembly (120) including a linear guide (122) and a linear moving member (124) slidable along the linear guide (122), the linear moving member (124) being provided with a plurality of toothed structures (124a) arranged substantially in a straight line;
an actuator (110) coupled to the linear moving member (124) and configured to reciprocate the linear moving member (124) in a direction parallel to the straight line;
a gear (130) meshing with the toothed structures (124a) of the linear moving member (124); and
a locking latch (140) disposed coaxially with and driven together with the gear (130), the locking latch (140) being rotatable between a first position and a second position.

2. The locking and unlocking module (100) as claimed in claim 1, wherein the transmission assembly (120) further comprises:
a connector (126) having a first end connected to the linear moving member (124) and a second end connected to the actuator (110); and
a floating joint (128) or a universal joint disposed at the second end of the connector (126).

3. The locking and unlocking module (100) as claimed in claim 1, wherein the actuator (110) is a pneumatic cylinder (110a).

4. The locking and unlocking module (100) as claimed in claim 3, wherein the pneumatic cylinder (110a) comprises a piston rod (112) and a stopper (152) disposed on the piston rod (112), the stopper (152) being configured to limit a stroke of the pneumatic cylinder (110a).

5. The locking and unlocking module (100) as claimed in claim 4, wherein the transmission assembly (120) further comprises:
a connector (126) connected to the linear moving member (124); and
a floating joint (128) or a universal joint having a first end screwed to the connector (126) and a second end screwed to the piston rod (112), and the stopper (152) being screwed to the piston rod (112).

6. The locking and unlocking module (100) as claimed in claim 4, wherein a moving direction of the piston rod (112) is parallel to a moving direction of the linear moving member (124).

7. The locking and unlocking module (100) as claimed in claim 1, wherein the linear moving member (124) is a rack, a linear gear, or a timing belt having linearly arranged gear teeth.

8. The locking and unlocking module (100) as claimed in claim 1, wherein the linear guide (122) comprises a rail (122a) and a slider (122b), the rail (122a) being fixed to a port door (12a), and the linear moving member (124) being fixed to the slider (122b).

9. The locking and unlocking module (100) as claimed in claim 1, wherein an angular difference between the first position and the second position is 90 degrees.

10. The locking and unlocking module (100) as claimed in claim 1, wherein a movement range of the linear moving member (124) is in a range from 10 mm to 35 mm.

11. A wafer carrier load port (10), comprising:
a frame (12) having a communication opening (12b) and a port door (12a), the port door (12a) being configured to cover the communication opening (12b);
a carrier platform (14) fixed to a first side of the frame (12) and configured to carry a wafer carrier (20, 20A), the wafer carrier (20, 20A) comprising a main body (21) and a door panel (22) facing the communication opening (12b), and the door panel (22) having a hole; and
a locking and unlocking module (100) disposed on a second side of the frame (12) opposite the carrier platform (14), the locking and unlocking module (100) comprising:
a transmission assembly (120) disposed on a first side of the port door (12a) opposite the carrier platform (14), the transmission assembly (120) comprising a linear guide (122) and a linear moving member (124) slidable along the linear guide (122), the linear moving member (124) being provided with a plurality of toothed structures (124a) arranged in a straight line, and the linear guide (122) being disposed on the port door (12a);
an actuator (110) disposed on the first side of the port door (12a) opposite the carrier platform (14) and coupled to the linear moving member (124), the actuator (110) being configured to reciprocate the linear moving member (124) in a direction parallel to the straight line;
a gear (130) disposed on the first side of the port door (12a) opposite the carrier platform (14) and meshing with the toothed structures (124a) of the linear moving member (124); and
a locking latch (140) including a first end portion and a second end portion opposite the first end portion, the port door (12a) being located between the first end portion and the second end portion, the locking latch (140) being disposed coaxially with and driven together with the gear (130), the locking latch (140) being rotatable to at least a first position and a second position, wherein, when the locking latch (140) is in the first position, the locking latch (140) mates with the hole of the door panel (22), and, when the locking latch (140) is in the second position, the door panel (22) is separable from the main body (21).

12. The wafer carrier load port (10) as claimed in claim 11, wherein the transmission assembly (120) further comprises:
a connector (126) having a first end connected to the linear moving member (124) and a second end connected to the actuator (110); and
a floating joint (128) or a universal joint disposed at the second end of the connector (126).

13. The wafer carrier load port (10) as claimed in claim 11, wherein the actuator (110) is a pneumatic cylinder (110a), the pneumatic cylinder (110a) comprises a piston rod (112) and a stopper (152) disposed on the piston rod (112), and the stopper (152) is configured to limit a stroke of the pneumatic cylinder (110a).

14. The wafer carrier load port (10) as claimed in claim 13, wherein the transmission assembly (120) further comprises:
a connector (126) connected to the linear moving member (124); and
a floating joint (128) or a universal joint having a first end screwed to the connector (126) and a second end screwed to the piston rod (112), and the stopper (152) being screwed to the piston rod (112).

15. The wafer carrier load port (10) as claimed in claim 11, wherein the linear guide (122) comprises a rail (122a) and a slider (122b), the rail (122a) being fixed to a port door (12a), and the linear moving member (124) being fixed to the slider (122b).
